# EUROPEAN PATENT APPLICATION

(11) **EP 1 870 927 A1**
(43) Date of publication of application: **26.12.2007**
(21) Application number: 06012756.0
(22) Date of filing: 21.06.2006
(51) Int. Cl.: H01L 21/18, H01L 29/267, H01L 29/861, H01L 29/78, H01L 21/04, H01L 29/24

(54) **Method of manufacturing a semiconductor device**

(71) Applicant: NISSAN MOTOR CO., LTD., Yokohama-shi Kanagawa-ken (JP)
(72) Inventor: Tanaka, Hideaki, Yokohama-shi Kanagawa-ken (JP); Hoshi, Masakatsu, Yokohama-shi Kanagawa-ken (JP); Shimoida, Yoshio, Yokosuka-shi Kanagawa-ken (JP); Hayashi, Tetsuya, Yokosuka-shi Kanagawa-ken (JP)
(74) Representative: Grünecker, Kinkeldey, Stockmair & Schwanhäusser Anwaltssozietät

(57) **Abstract**

The present invention provides a method of manufacturing a semiconductor device. The semiconductor device comprises a semiconductor base made of a first semiconductor material; and a hetero-semiconductor region made of a second semiconductor material having a different band gap from the first semiconductor material and forming a heterojunction with the semiconductor base. The formation of the heterojunction is accomplished by bonding together the semiconductor base and a substrate made of the second semiconductor material.

## Description

### BACKGROUND OF THE INVENTION

The invention relates to a method of manufacturing a semiconductor device having a hetero-semiconductor region.

The earlier technology, as cited backgrounds to the invention, include a semiconductor device disclosed in Japanese Patent Laid-open Official Gazette No. 2003-319398, filed by the applicant.

The semiconductor device of earlier technology comprises a semiconductor base, which is configured of an n⁺ type silicon carbide substrate and an n⁻ type silicon carbide epitaxial region formed thereon; and n⁻ type and n⁺ type polycrystalline silicon regions formed in contact with one main surface of the semiconductor base. In the semiconductor device, the epitaxial region and the n⁻ type and n⁺ type polycrystalline silicon regions are joined together to form heterojunctions. The semiconductor device also comprises a gate electrode formed adjacent to the junction between the epitaxial region and the n⁺ type polycrystalline silicon region with a gate insulating film in between. The semiconductor device also comprises a source electrode having a connection to the n⁻ type polycrystalline silicon region; and a drain electrode formed on a rear surface of the n⁺ type silicon carbide substrate.

The semiconductor device configured as mentioned above is used with its source electrode grounded and with its drain electrode subjected to apply a predetermined positive potential. In this state, the semiconductor device serves as a switch by controlling the potential of the gate electrode. Specifically, with the gate electrode grounded, a reverse bias is applied to the heterojunctions between the n⁻ type and n⁺ type polycrystalline silicon regions and the epitaxial region, so that no current is passed between the drain electrode and the source electrode. With the gate electrode subjected to a predetermined positive voltage, a gate electric field, however, acts on a heterojunction interface between the n⁺ type polycrystalline silicon region and the epitaxial region, thus causes a decrease in the thickness of an energy barrier formed by a heterojunction surface of a gate oxide film interface, and thus allows the passage of a current between the drain and source electrodes. The semiconductor device of earlier technology utilizes the heterojunction as a control channel for the cutoff or conduction of the current. Thus, the semiconductor device can have a channel length substantially equivalent to the thickness of a heterobarrier, which is sufficient for the functioning of the semiconductor device. The semiconductor device can therefore achieve the characteristics of low-resistance conduction.

Incidentally, a polycrystalline silicon layer formed by sputtering, CVD (chemical vapor deposition) or other methods has been heretofore used as a hetero-semiconductor region, which is formed on a silicon carbide base to form a heterojunction with the silicon carbide base.

### SUMMARY OF THE INVENTION

In the semiconductor device of earlier technology, polycrystalline silicon is used as the hetero-semiconductor region. Due to this, a large amount of dangling bonds(non-bonded hand) present on grain boundaries between crystal grains act as an interface state to thus cause a reduction in carrier mobility and lead to a drop in drive current, which is a problem involved in the semiconductor device of earlier technology.

An object of the invention is to provide a method of manufacturing a semiconductor device capable of reducing the occurrence of an interface state and thereby increasing a drive current.

In order to solve the foregoing problem, the present invention provides a method of manufacturing a semiconductor device. The semiconductor device comprises a semiconductor base made of a first semiconductor material; and a hetero-semiconductor region made of a second semiconductor material having a different band gap from the first semiconductor material and forming a heterojunction with the semiconductor base. The formation of the heterojunction is accomplished by bonding together the semiconductor base and a substrate made of the second semiconductor material.

### BRIEF DESCRIPTION OF THE DRAWINGS

Fig. 1 is a sectional view of a semiconductor device (specifically a diode) according to a first embodiment of the present invention;
Figs. 2A to 2H are sectional views showing steps in a process for manufacturing the semiconductor device according to the first embodiment of the present invention;
Fig. 3 is a sectional view of a semiconductor device (specifically a diode) according to a second embodiment of the present invention;
Figs. 4A to 4G are sectional views showing steps in a process for manufacturing the semiconductor device according to the second embodiment of the present invention;
Fig. 5 is a sectional view of a semiconductor device (specifically a transistor) according to a third embodiment of the present invention;
Figs. 6A to 6L are sectional views showing steps in a process for manufacturing the semiconductor device according to the third embodiment of the present invention;
Figs. 7A and 7B are sectional views of other configurations of the semiconductor device (specifically the transistor) according to the third embodiment of the present invention; and
Figs. 8A to 8D are sectional views showing steps in a manufacturing process, illustrating the general outline of a method of manufacturing a semiconductor device according to the first embodiment of the present invention.

### DETAILED DESCRIPTION OF THE PREFERRED EMBODIMENTS

Embodiments of the present invention will be described in detail below with reference to the drawings. In the drawings to be hereinafter described, the same reference numerals designate parts having the same functions, and the repeated description of these parts is omitted.

### [First embodiment]

### [Configuration]

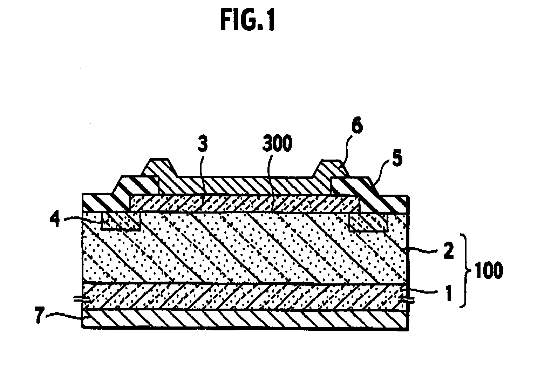

Fig. 1 is a sectional view of a semiconductor device (specifically a diode) according to a first embodiment of the present invention.

The semiconductor device of the first embodiment comprises a silicon carbide (SiC) semiconductor base 100, which is configured of an n type silicon carbide substrate 1 and an n type silicon carbide epitaxial layer 2 formed thereon. The semiconductor device comprises a hetero-semiconductor region 3, which is made of, for example, p type single crystal silicon (Si) so as to form a heterojunction 300 with the silicon carbide epitaxial layer 2. Each end of the heterojunction 300 terminates with a field limiting region 4 made of a p type semiconductor layer. The semiconductor device comprises a cathode 7 formed in contact with the silicon carbide substrate 1, and an anode 6 formed in contact with the hetero-semiconductor region 3. Numeral 5 denotes an interlayer insulating film.

In the semiconductor device of the first embodiment, the conduction type of the hetero-semiconductor region 3 is opposite to that of the semiconductor base 100. With this configuration, the semiconductor device can achieve a reduction in leakage current and thus achieve higher breakdown voltage.

### [Method of manufacture]

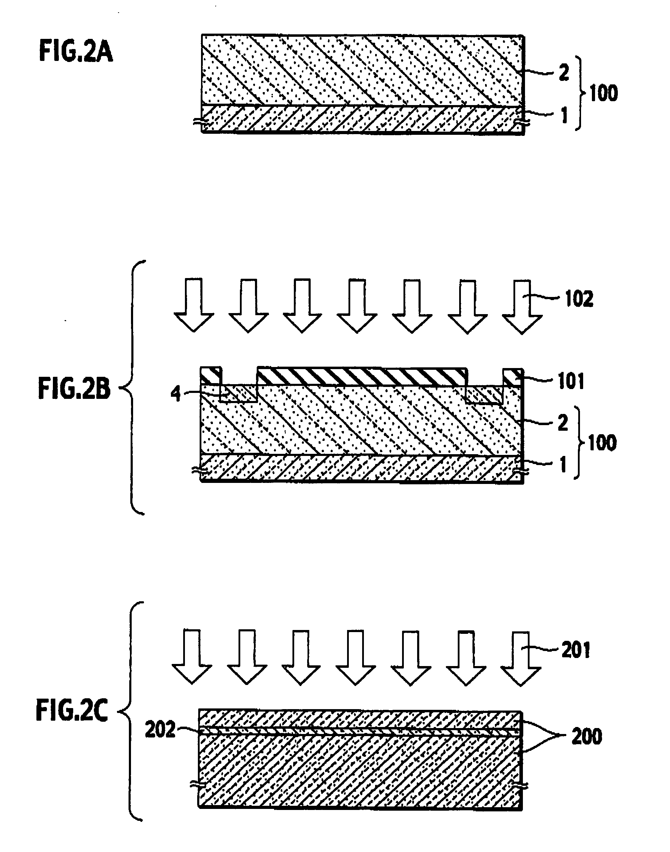

The description will be given below with reference to Figs. 2A to 2H with regard to a method of manufacturing the semiconductor device according to the first embodiment shown in Fig. 1. Figs. 2A to 2H are sectional views showing steps in a manufacturing process.

As shown in Fig. 2A, a silicon carbide base 100 is first prepared by growing an n type silicon carbide epitaxial layer 2 on an n type silicon carbide substrate 1. The silicon carbide epitaxial layer 2 has a thickness of, for example, 10 µm and an impurity concentration of, for example, 1.0 × 10¹⁶ *cm*⁻³.

As shown in Fig. 2B, a p type field limiting region 4 is then formed by implanting aluminum (Al) ions 102 in a predetermined region of the silicon carbide epitaxial layer 2, using a CVD oxide film 101 or the like as a mask. The conditions of ion implantation are, for example, as follows: multistep implantation at accelerating voltages of 30 to 360 keV; a total dose of 5.0×10¹⁶ *cm*⁻³; and a substrate temperature of 800 degrees. After the ion implantation, the CVD oxide film 101 is removed by using a BHF (buffered hydrofluoric acid) solution or the like. Activation annealing occurs to activate the implanted aluminum. The conditions of activation annealing are, for example, 1700 degrees and 10 minutes in an atmosphere of argon.

As shown in Fig. 2C, a p type single crystal silicon substrate 200 is then prepared by implanting hydrogen (H) ions 201 in the surface of the substrate 200 at room temperature to thereby form a hydrogen ion implanted layer 202 with a predetermined thickness at a predetermined depth below the surface of the substrate 200. In this step, the single crystal silicon substrate 200 has an impurity concentration of, for example, 1.0×10²⁰ *cm*⁻³. The conditions of hydrogen ion implantation are, for example, an accelerating voltage of 100 keV and a dose of 1.0×10¹⁶ *cm*⁻².

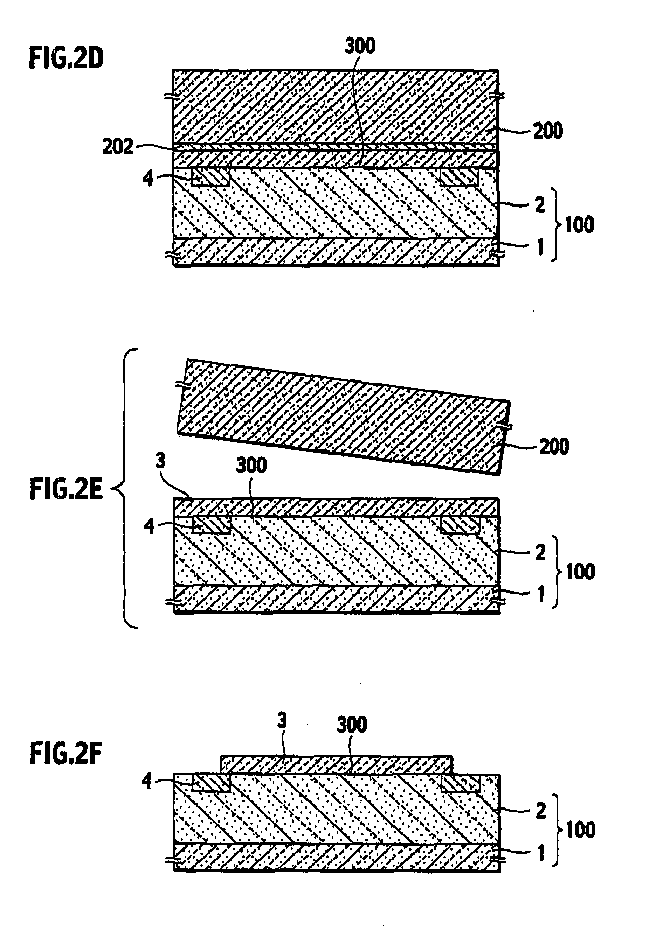

As shown in Fig. 2D, the silicon carbide semiconductor base 100 and the p type single crystal silicon substrate 200 are then bonded together. Specifically, silicon carbide epitaxial layer 2, having the p type field limiting region 4 formed therein, of the semiconductor base 100 is bonded to the side, implanted with the hydrogen ions 201, of the silicon substrate 200 having the hydrogen ion implanted layer 202 formed therein. Specifically, heat or pressure application takes place to covalently bond elements on an interface. This results in a heterojunction 300.

After bonding, heating occurs at 600 degrees in an atmosphere of nitrogen. As shown in Fig. 2E, the silicon substrate 200 is peeled off along a boundary formed by the hydrogen ion implanted layer 202. After peeling, thermal oxidation occurs to flatten the surface of a resultant hetero-semiconductor region 3. A resultant oxide film is removed by means of a BHF solution.

As shown in Fig. 2F, the hetero-semiconductor region 3 is then patterned by using photolithography and etching. In this step, patterning occurs in such a manner that each end of the hetero-semiconductor region 3 terminates on the field limiting region 4.

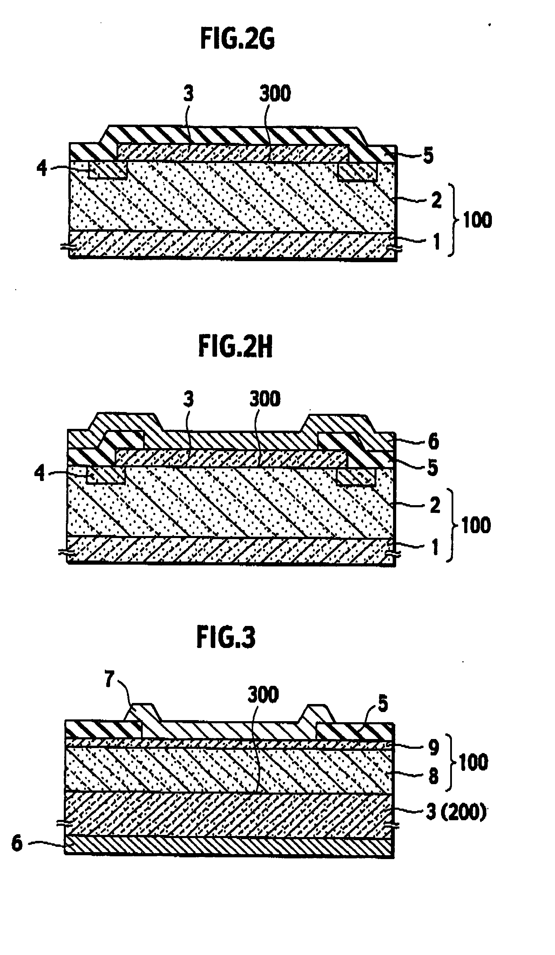

After the patterning of the hetero-semiconductor region 3, an oxide film is deposited to form an interlayer insulating film 5, as shown in Fig. 2G.

Then, as shown in Fig. 2H, a contact hole is formed in the interlayer insulating film 5 by using photolithography and etching. Aluminum to form an anode 6 is sputter deposited in contact with the hetero-semiconductor region 3.

Finally, as shown in Fig. 1, the anode 6 is formed by using photolithography and etching to pattern an aluminum layer. Titanium and nickel are sputter deposited in this sequence in contact with the silicon carbide substrate 1. This results in the completion of the semiconductor device (specifically the diode) shown in Fig. 1.

As described above, the first embodiment provides the method of manufacturing the semiconductor device. The semiconductor device includes the semiconductor base 100 made of a first semiconductor material (e.g., silicon carbide employed herein); and the hetero-semiconductor region 3 made of a second semiconductor material (e.g., silicon employed herein) having a different band gap from the first semiconductor material and forming the heterojunction 300 with the semiconductor base 100. The formation of the heterojunction 300 is accomplished by bonding together the semiconductor base 100 and the substrate 200 made of the second semiconductor material.

As mentioned above, the single crystal substrate 200, such as silicon, is bonded to the semiconductor base 100, such as silicon carbide, to form the hetero-semiconductor region 3. Thus, the method of the first embodiment can form the hetero-semiconductor region 3 made of high-quality single crystal silicon, without having to use a special process such as laser anneal.

Specifically, the first embodiment has advantageous effects (1) to (4) as given below.
(1) To form a hetero-semiconductor region made of single crystals such as silicon, the earlier technology previously mentioned requires a special process such as laser anneal, which leads to an increase in the costs of manufacturing process. However, the first embodiment facilitates forming the hetero-semiconductor region 3 made of single crystals, thus enabling a reduction in the costs of manufacturing process.
(2) The earlier technology uses polycrystalline silicon in a polycrystalline, that is, unstable state to form a hetero-semiconductor region. In this case, the earlier technology must allow for a considerable margin for the conditions of manufacturing process (mainly, impurity diffusion). Moreover, impurities are prone to diffuse or segregate along grain boundaries between crystal grains. One of essentials for miniaturization is to meet strict conditions of manufacturing process, such as conductance control on minute regions. The earlier technology, however, has difficulty in meeting the strict conditions because of the foregoing problem. The earlier technology is therefore limited in the integration of unit cells and thus has difficulty in reducing on-state resistance. On the other hand, the first embodiment can form the hetero-semiconductor region 3 made of single crystals. Therefore, the first embodiment requires only a narrow range of margin for the conditions of manufacturing process (mainly, impurity diffusion), thus facilitates meeting the conditions of manufacturing process, thus has an advantage in miniaturization, and thus facilitates reducing the on-state resistance.
(3) The resistance of polycrystalline silicon for use in the earlier technology is about two to three times higher than that of single crystal silicon. This leads to high source resistance, which interferes with a reduction in on-state resistance. Since the first embodiment can form the hetero-semiconductor region 3 made of single crystal silicon, the first embodiment can reduce the source resistance and thus easily reduce the on-state resistance.
(4) A large amount of dangling bonds are present on the surfaces of crystal grains of polycrystalline silicon (that is, on the grain boundaries between the crystal grains). The dangling bonds serve as an interface state to thus reduce carrier mobility and decrease a drive current. Since the first embodiment can form the hetero-semiconductor region 3 made of single crystal silicon, the first embodiment can increase the carrier mobility and thus increase the drive current.

There is also provided the method of manufacturing the semiconductor device (specifically the diode). The diode includes the semiconductor base 100 made of the first semiconductor material; the hetero-semiconductor region 3 made of the second semiconductor material having a different band gap from the first semiconductor material and forming the heterojunction 300 with the semiconductor base 100; the cathode 7 formed in contact with the semiconductor base 100; and the anode 6 formed in contact with the hetero-semiconductor region 3. The formation of the heterojunction 300 is accomplished by bonding together the semiconductor base 100 and the substrate 200 made of the second semiconductor material. This method can achieve the same effects as mentioned above.

The method of manufacturing the semiconductor device also includes the act of implanting the hydrogen ions 201 in a predetermined region of the substrate 200; the act of bonding together the substrate 200 and the semiconductor base 100 (see Fig. 2D); and the act of separating a part of the substrate 200 along the boundary formed by the predetermined region (specifically the hydrogen ion implanted layer 202) implanted with the hydrogen ions 201.

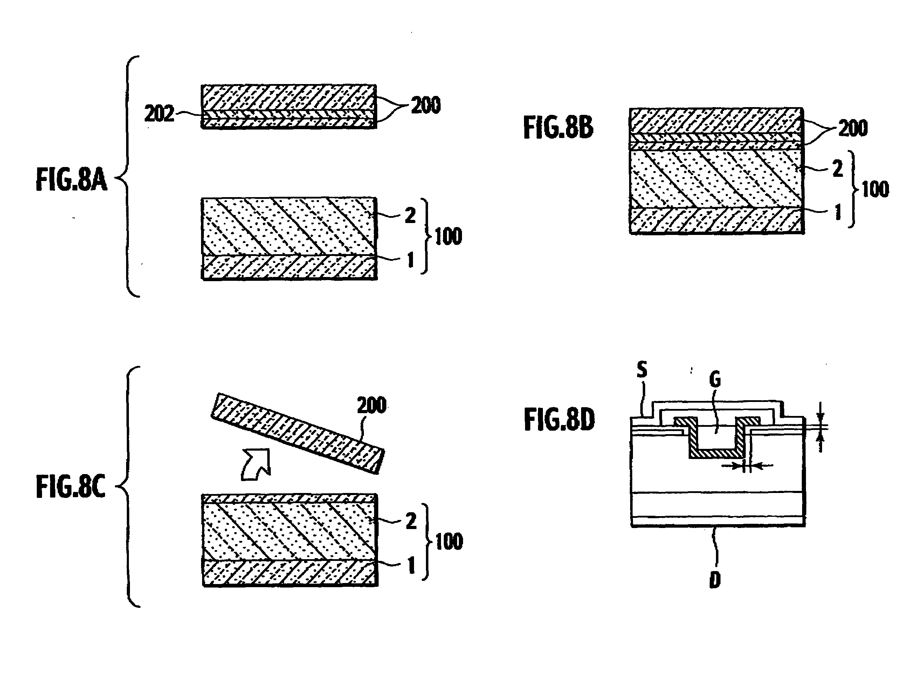

Figs. 8A to 8D are sectional views showing steps in a manufacturing process, illustrating the general outline of a method of manufacturing a semiconductor device according to the first embodiment. Specifically, as shown in Fig. 8A, there are prepared, for example, the silicon carbide base 100 and the single crystal silicon substrate 200 implanted with a higher concentration of hydrogen ions. The thickness of a single crystal silicon layer to be formed on the silicon carbide base 100 can be controlled according to the position (or depth) of the hydrogen ion implanted layer 202 formed within the single crystal silicon substrate 200. As shown in Fig. 8B, the silicon carbide base 100 and the single crystal silicon substrate 200 are then bonded together. Pressure application or the like takes place to form covalent bonds on the SiC-Si interface. As shown in Fig. 8C, heating then occurs to separate the single crystal silicon substrate 200. The single crystal silicon substrate 200 is separated into two parts along the boundary formed by the hydrogen ion implanted layer 202. As shown in Fig. 8D, the device is then formed in the same manner as methods of earlier technology. Using the so-called smart cut method, as mentioned above, allows forming a silicon substrate into a thin film (e.g., forming the hetero-semiconductor region 3 employed in the first embodiment) with ease and high accuracy.

In the method of the first embodiment, the first semiconductor material is silicon carbide. Although other wide-gap semiconductor materials may be used, silicon carbide is desirable because of having the great merits in manufacturing process, such as the merit of permitting the use of thermal oxidation and the merit of facilitating conductance control on minute regions indicated by the arrows of Fig. 8D. In addition, silicon carbide can realize the semiconductor device having high withstand voltage.

In the method of the first embodiment, the second semiconductor material is silicon. Although other semiconductor materials may be used, single crystal silicon is desirable because of having the great merits in manufacturing process, such as the merit of permitting the use of thermal oxidation and the merit of facilitating conductance control on the minute regions indicated by the arrows of Fig. 8D.

### [Second embodiment]

### [Configuration]

Fig. 3 is a sectional view of a semiconductor device (specifically a diode) according to a second embodiment of the invention.

The semiconductor device of the second embodiment includes a p type hetero-semiconductor region 3 (which constitutes part of a single crystal silicon substrate 200); and a silicon carbide semiconductor base 100, which is configured of an n type silicon carbide layer 8 and a higher n type silicon carbide layer 9, which are formed on the hetero-semiconductor region 3. As employed herein, the term "concentration" refers to an impurity concentration. A heterojunction 300 is formed between the silicon carbide layer 8 and the hetero-semiconductor region 3. The semiconductor device includes a cathode 7 formed in contact with the higher concentration n type silicon carbide layer 9, and an anode 6 formed in contact with the hetero-semiconductor region 3 (which constitutes part of the single crystal silicon substrate 200). In Fig. 3, numeral 5 denotes an interlayer insulating film.

### [Method of manufacture]

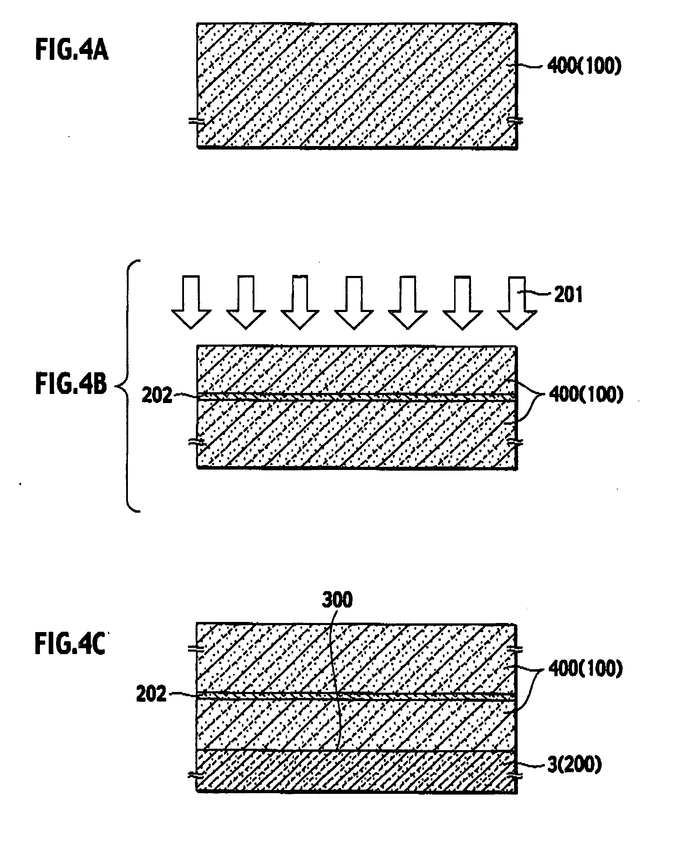

The description will be given below with reference to Figs. 4A to 4G with regard to a method of manufacturing the semiconductor device according to the second embodiment shown in Fig. 3. Figs. 4A to 4G are sectional views showing steps in a manufacturing process.

As shown in Fig. 4A, a low-concentration n type silicon carbide substrate 400 is first prepared. The low-concentration n type silicon carbide substrate 400 has an impurity concentration of, for example, 1.0 × 10¹⁶ *cm*^{*-*3}*.*

As shown in Fig. 4B, hydrogen ions 201 are then implanted in the surface of the low-concentration n type silicon carbide substrate 400 at room temperature to thereby form a hydrogen ion implanted layer 202 with a predetermined thickness at a predetermined depth below the surface of the substrate 400. In this step, the conditions of hydrogen ion implantation are, for example, an accelerating voltage of 400 eV and a dose of 3.0 × 10¹⁶ *cm*⁻².

As shown in Fig. 4C, the low-concentration n type silicon carbide substrate 400 and the p type single crystal silicon substrate 200 are then bonded together. Specifically, the side, implanted with the hydrogen ions 201, of the silicon carbide substrate 400 having the hydrogen ion implanted layer 202 formed therein is bonded to the single crystal silicon substrate 200. Specifically, heat or pressure application takes place to covalently bond elements on an interface. This results in a heterojunction 300. In this step, the single crystal silicon substrate 200 has an impurity concentration of, for example, 1.0 × 10²⁰ *cm*⁻³.

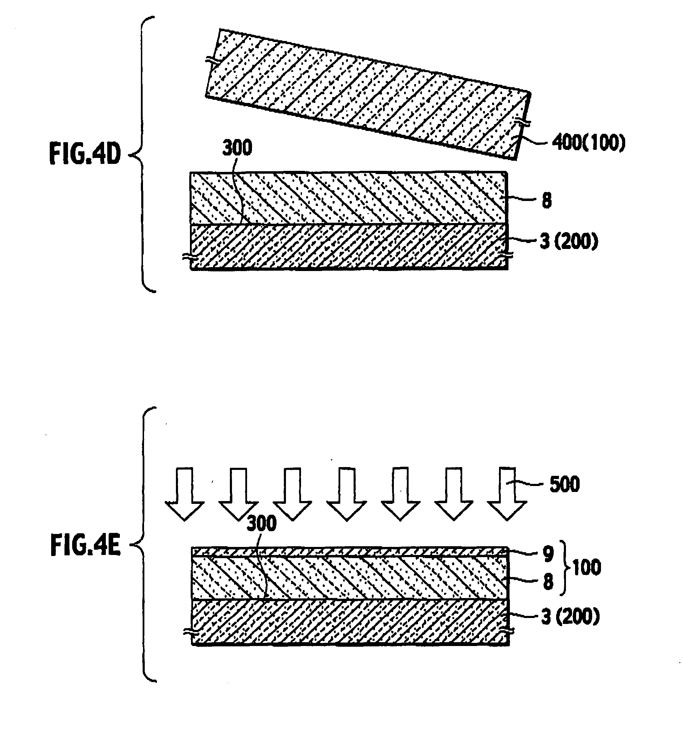

After bonding, heating occurs at 600 degrees in an atmosphere of nitrogen. As shown in Fig. 4D, the low-concentration n type silicon carbide substrate 400 is peeled off along a boundary formed by the hydrogen ion implanted layer 202. After peeling, thermal oxidation occurs to flatten the surface of a resultant silicon carbide layer 8. A resultant oxide film is removed by means of a BHF solution.

As shown in Fig. 4E, phosphorus (P) ions 500 are then implanted in the surface of the silicon carbide layer 8 at a substrate temperature of 600 degrees. In this step, the conditions of ion implantation are, for example, an accelerating voltage of 50 eV, a dose of 3.0×10¹⁶*cm*⁻², and a substrate temperature of 600 degrees. After the implantation, activation annealing occurs to activate the implanted phosphorus and thus form a higher concentration n type silicon carbide layer 9. The conditions of activation annealing are, for example, 1200 degrees and 12 hours in an atmosphere of nitrogen.

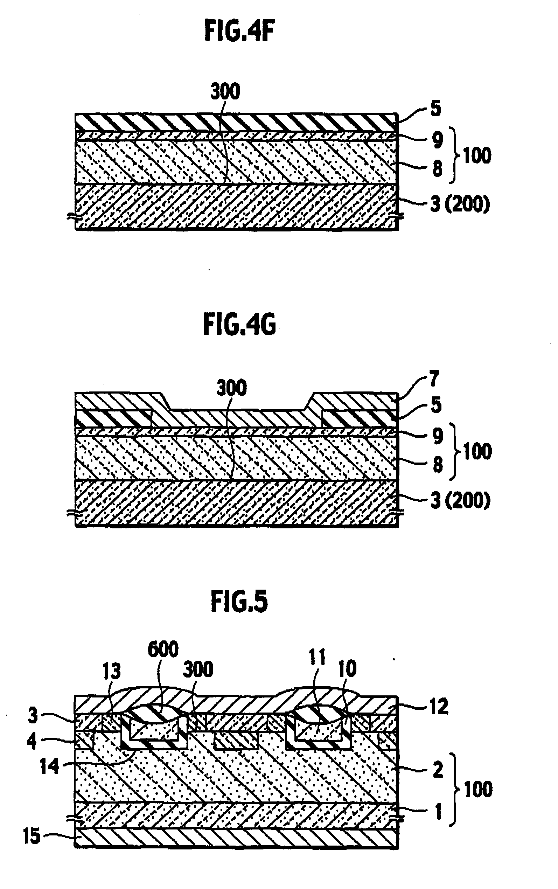

As shown in Fig. 4F, an oxide film is then deposited on the higher concentration n type silicon carbide layer 9 to thereby form an interlayer insulating film 5.

Then, as shown in Fig. 4G, a contact hole is formed in the interlayer insulating film 5 by using photolithography and etching. Titanium and aluminum to form a cathode 7 are sputter deposited in this sequence in contact with the higher concentration n type silicon carbide layer 9.

Finally, as shown in Fig. 3, the cathode 7 is formed by using photolithography and etching to pattern an aluminum layer and a titanium layer. An anode 6 is formed by sputter depositing aluminum in contact with the p type single crystal silicon substrate 200 which is the hetero-semiconductor region 3. This results in the completion of the semiconductor device (specifically the diode) shown in Fig. 3.

The method of manufacturing the semiconductor device according to the second embodiment includes: the act of implanting the hydrogen ions 201 in a predetermined region of the silicon carbide substrate 400; the act of bonding together the silicon carbide substrate 400 and the substrate 200; and the act of separating a part of the silicon carbide substrate 400 along the boundary formed by the predetermined region (specifically the hydrogen ion implanted layer 202) implanted with the hydrogen ions. In the case of the earlier technology previously mentioned, the silicon carbide substrate constitutes almost the entire area of the silicon carbide base. The silicon carbide substrate serves only as a support substrate for the silicon carbide epitaxial layer which ensures breakdown voltage, or serves only as a contact layer for the drain electrode or the cathode. When operating as the semiconductor device, the silicon carbide substrate acts merely as a resistor. Thus, the resistance of the substrate has a direct influence upon on-state resistance and interferes with a reduction in on-state resistance. When the method of manufacturing the semiconductor device according to the second embodiment is used for manufacture, the silicon carbide substrate 400 is almost wholly occupied only by the region which ensures breakdown voltage, and there is no region corresponding to the silicon carbide substrate which has heretofore acted as the resistor. Thus, the method of the second embodiment can achieve a further reduction in on-state resistance. As compared to silicon, the silicon carbide substrate is very costly and leads to an increase in manufacturing costs. In the second embodiment, the silicon carbide substrate 400, after being peeled off (see Fig. 4D), is again bondable and usable. Thus, one and the same substrate is reusable many times. In short, the second embodiment can also achieve cost reduction.

### [Third embodiment]

### [Configuration]

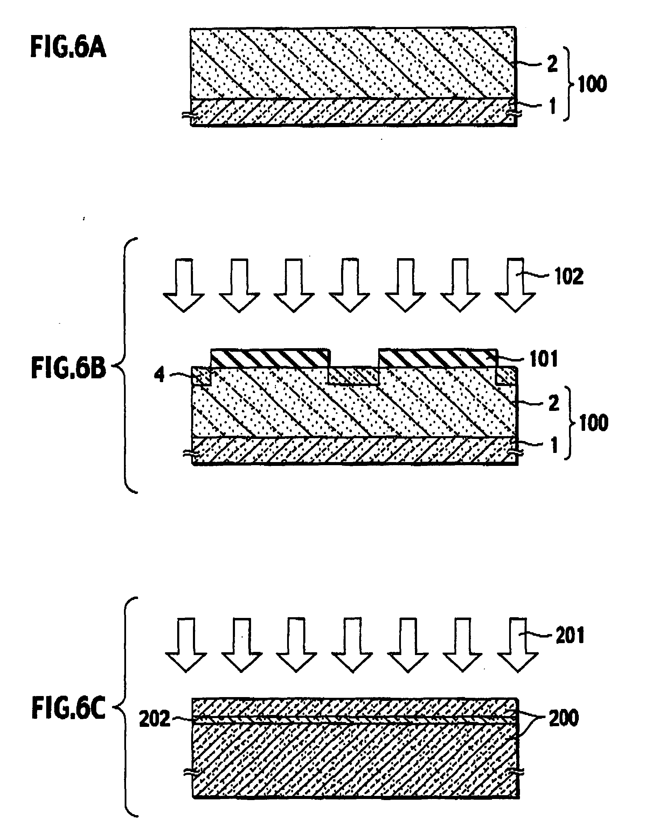

Fig. 5 is a sectional view of a semiconductor device (specifically a transistor) according to a third embodiment of the invention. In Fig. 5, there is shown a structure in which two structural unit cells are arranged in series.

The semiconductor device of the third embodiment includes a silicon carbide semiconductor base 100, which is configured of an n type silicon carbide substrate 1 and an n type silicon carbide epitaxial layer 2 formed thereon. A p type field limiting region 4 is formed in a predetermined region of the silicon carbide epitaxial layer 2. The semiconductor device comprises hetero-semiconductor regions 3 and 13, which are made of p type single crystal silicon and n type single crystal silicon, respectively, and are formed on the silicon carbide epitaxial layer 2 to form heterojunctions 300 with the silicon carbide epitaxial layer 2. A trench 14 is formed so as to penetrate in the depth direction through the n type single crystal silicon hetero-semiconductor region 13 and to the silicon carbide epitaxial layer 2. The semiconductor device includes a gate electrode 11 formed within the trench 14 with a gate insulating film 10 in between. The semiconductor device includes a source electrode 12 formed in contact with the hetero-semiconductor regions 3 and 13 made of p type and n type single crystal silicon, respectively; and a drain electrode 15 formed in contact with the silicon carbide substrate 1. A cap oxide film 600 provides electrical isolation between the gate electrode 11 and the p type and n type single crystal silicon hetero-semiconductor regions 3 and 13 and source electrode 12.

In the semiconductor device of the third embodiment, the hetero-semiconductor regions 3 and 13 are electrically connected and are at the same potential. Thus, respective heterojunction diodes formed by the hetero-semiconductor regions 3 and 13 are connected in parallel, thus enabling the passage of a larger current during back-flow operation. Moreover, the conduction type of the hetero-semiconductor region 3 is opposite to that of the semiconductor base 100. Thus, the semiconductor device can achieve a reduction in leakage current and thus achieve higher breakdown voltage. Moreover, a combination of the p type and n type hetero-semiconductor regions 3 and 13 yields both high reverse breakdown voltage and low on-state resistance.

### [Method of manufacture]

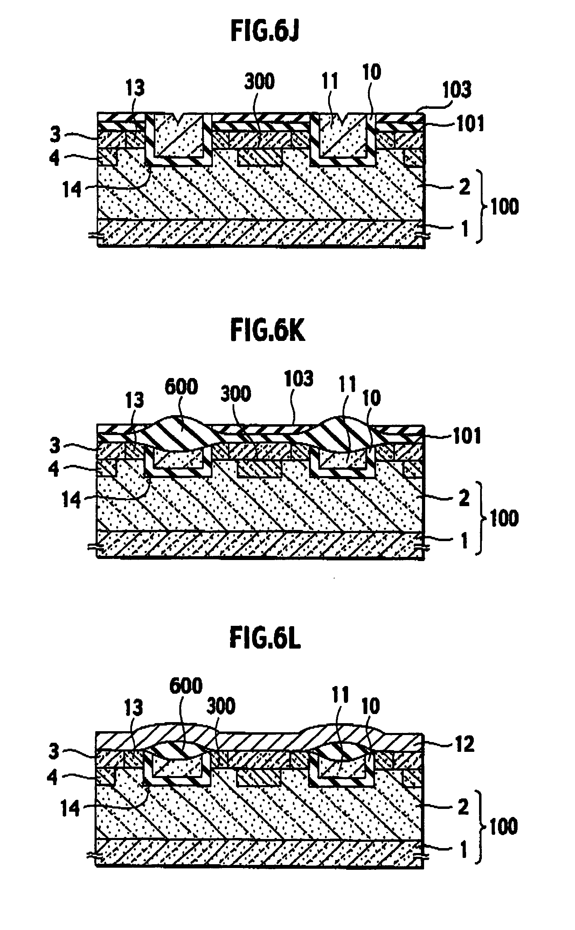

The description will be given below with reference to Figs. 6A to 6L with regard to a method of manufacturing the semiconductor device according to the third embodiment shown in Fig. 5. Figs. 6A to 6L are sectional views showing steps in a manufacturing process.

As shown in Fig. 6A, a silicon carbide base 100 is first prepared by growing an n type silicon carbide epitaxial layer 2 on an n type silicon carbide substrate 1. The silicon carbide epitaxial layer 2 has a thickness of, for example, 10 µm and an impurity concentration of, for example, 1.0 × 10¹⁶ *cm*⁻³*.*

As shown in Fig. 6B, a p type field limiting region 4 is then formed by implanting aluminum ions 102 in a predetermined region of the silicon carbide epitaxial layer 2, using a CVD oxide film 101 or the like as a mask. The conditions of ion implantation are, for example, as follows: multistep implantation at accelerating voltages of 30 to 360 keV; a total dose of 5.0× 10¹⁶ *cm*⁻³; and a substrate temperature of 800 degrees. After the ion implantation, the CVD oxide film 101 is removed by using a BHF solution or the like. Activation annealing occurs to activate the implanted aluminum. The conditions of activation annealing are, for example, 1700 degrees and 10 minutes in an atmosphere of argon.

As shown in Fig. 6C, a p type single crystal silicon substrate 200 is then prepared by implanting hydrogen ions 201 in the surface of the substrate 200 at room temperature to thereby form a hydrogen ion implanted layer 202 with a predetermined thickness at a predetermined depth below the surface of the substrate 200. In this step, the single crystal silicon substrate 200 has an impurity concentration of, for example, 1.0×10²⁰ *cm*⁻³*.* The conditions of hydrogen ion implantation are, for example, an accelerating voltage of 100 keV and a dose of 1.0×10¹⁶ *cm-*² *.*

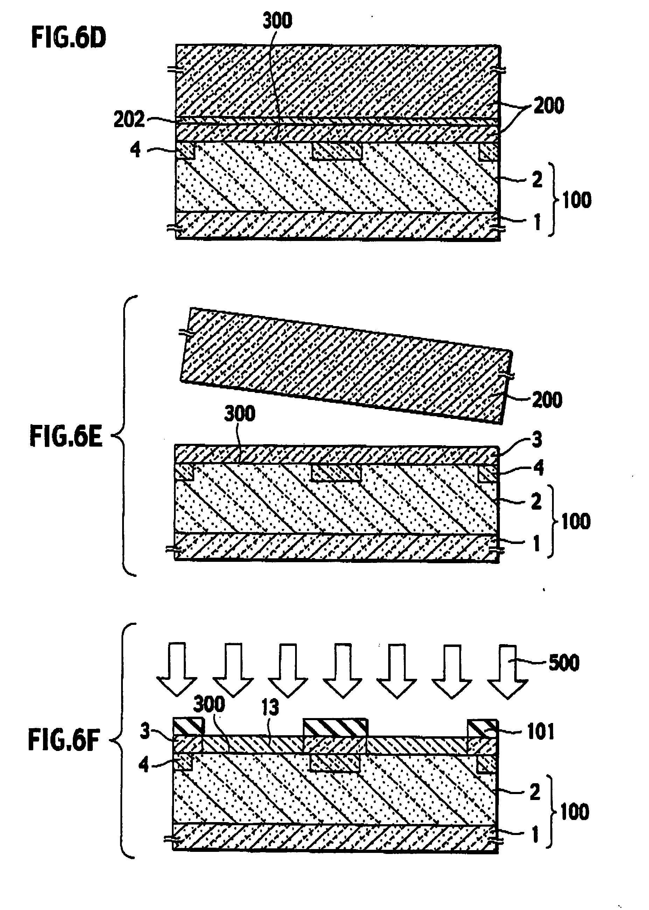

As shown in Fig. 6D, the silicon carbide semiconductor base 100 and the p type single crystal silicon substrate 200 are then bonded together. Specifically, the silicon carbide epitaxial layer 2, having the field limiting region 4 formed therein, of the semiconductor base 100 is bonded to the side, implanted with the hydrogen ions 201, of the silicon substrate 200 having the hydrogen ion implanted layer 202 formed therein. Specifically, heat or pressure application takes place to covalently bond among elements on an interface. This results in a heterojunction 300.

After bonding, heating occurs at 600 degrees in an atmosphere of nitrogen. As shown in Fig. 6E, the silicon substrate 200 is peeled off along a boundary formed by the hydrogen ion implanted layer 202. After peeling, thermal oxidation occurs to flatten the surface of a resultant hetero-semiconductor region 3. A resultant oxide film is removed by means of a BHF solution.

As shown in Fig. 6F, phosphorus (P) ions 500 are then implanted in a predetermined region of the p type single crystal silicon hetero-semiconductor region 3 at room temperature, using a CVD oxide film 101 or the like as a mask. After ion implantation, the CVD oxide film 101 is removed by using a BHF solution or the like. Activation annealing occurs to activate the implanted phosphorus (P) and thus form a hetero-semiconductor region 13 made of n type single crystal silicon. In this step, the conditions of ion implantation are, for example, an accelerating voltage of 80 keV and a dose of 1.0×10¹⁵ *cm*⁻² . The conditions of activation annealing are, for example, 1000 degrees and 1 minute in an atmosphere of argon. Incidentally, diffusion process such as solid phase diffusion may be used to dope the predetermined region of the p type single crystal silicon hetero-semiconductor region 3 with phosphorus.

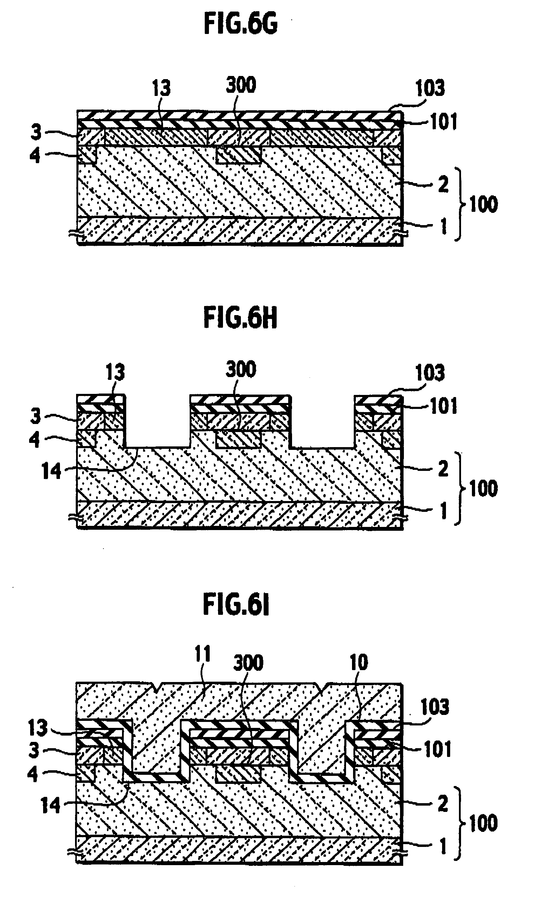

As shown in Fig. 6G, an oxide film 101 and a silicon nitride film 103 are then deposited in this sequence on the hetero-semiconductor regions 3 and 13 made of p type and n type single crystal silicon, respectively.

As shown in Fig. 6H, a trench 14 is then formed so as to extend to the silicon carbide epitaxial layer 2, by using photolithography and etching to etch away the oxide film 101, the silicon nitride film 103, and the hetero-semiconductor region 13 made of n type single crystal silicon.

As shown in Fig. 6I, a gate insulating film 10 made of a TEOS (tetraethylorthosilicate) film is then formed along an inner wall of the trench 14. A polycrystalline silicon layer to form a gate electrode 11 is formed so as to fill in the trench 14. After the formation of the polycrystalline silicon layer, the polycrystalline silicon layer is doped with phosphorus (P) in an atmosphere of POCl₃. Incidentally, ion implantation may be used to dope the polycrystalline silicon layer with phosphorus.

As shown in Fig. 6J, the gate electrode 11 is then formed by etching back the polycrystalline silicon layer.

Then, the gate electrode 11 is partially subjected to thermal oxidation to thereby form a cap oxide film 600. In this step, a region coated with the silicon nitride film 103 is oxidized at an extremely slow rate, so that the cap oxide film 600 is formed only in part of the gate electrode 11, as shown in Fig. 6K.

Then, as shown in Fig. 6L, the silicon nitride film 103 is removed by means of a phosphoric acid, and thereafter, the oxide film 101 formed under the silicon nitride film 103 is etched back. In the previous step of forming the cap oxide film 600 through thermal oxidation of part of the gate electrode 11 made of polycrystalline silicon, the cap oxide film 600 is formed with a great thickness such that the cap oxide film 600 remains even after etch back, although partly etched due to the etch back. After the etch back, aluminum to form a source electrode 12 is sputter deposited in contact with the hetero-semiconductor regions 3 and 13 made of p type and n type single crystal silicon, respectively.

Finally, as shown in Fig. 5, a drain electrode 15 is formed by sputter depositing titanium and nickel in this sequence in contact with the silicon carbide substrate 1. This results in the completion of the semiconductor device (specifically the transistor) shown in Fig. 5.

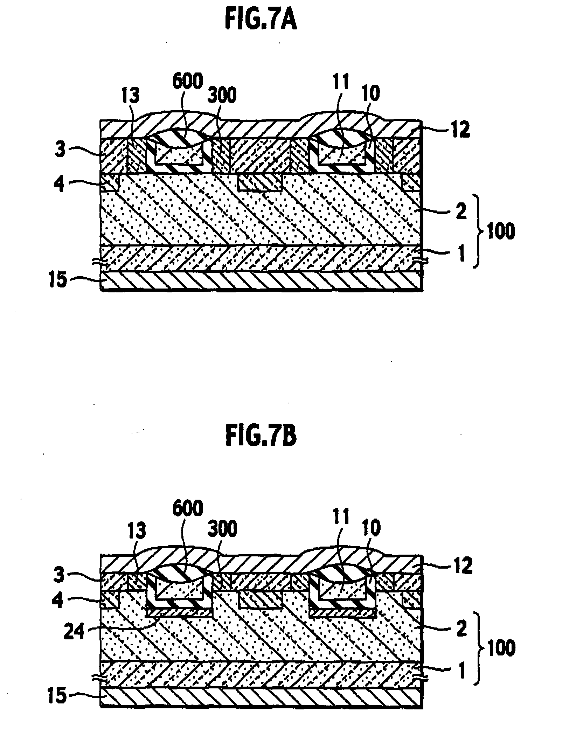

Incidentally, the semiconductor device (specifically the transistor) of the third embodiment may have a planar structure in which the trench 14 is not formed in the silicon carbide epitaxial layer 2 as shown in Fig. 7A, or may have a structure in which the p type field limiting region 4 is disposed directly under the gate electrode 11 as shown in Fig. 7B.

As described above, the semiconductor device of the third embodiment is, for example, a heterojunction interface modulation device having an Si-SiC heterojunction interface, based on applications of wafer bonding technique for use in the third embodiment, an SOI (silicon on insulator) wafer, or the like. The third embodiment provides the method of manufacturing the semiconductor device (specifically the transistor). The transistor includes: the semiconductor base 100 made of a first semiconductor material; the hetero-semiconductor regions 3 and 13 having a different band gap from the first semiconductor material and forming the heterojunctions 300 with the semiconductor base 100; the gate electrode 11 disposed adjacent to the heterojunction 300 and in contact with the heterojunction 300 with the gate insulating film 10 in between; the source electrode 12 formed in contact with the hetero-semiconductor regions 3 and 13; and the drain electrode 15 formed in contact with the semiconductor base 100. The formation of the heterojunction 300 is accomplished by bonding together the semiconductor base 100 and the substrate 200 made of the second semiconductor material. The method of the third embodiment can form the hetero-semiconductor regions 3 and 13 made of single crystal silicon, that is, a source region. Thus, the method of the third embodiment can reduce source resistance, as compared to methods of earlier technology in which polycrystalline silicon is used for the hetero-semiconductor region. Therefore, the method of the third embodiment can achieve low on-state resistance. The method of the third embodiment, of course, can achieve cost reduction, because of not having to use a special process such as laser anneal. Moreover, in the third embodiment, no gap (or grain boundary) develops between crystal grains. Thus, the method of the third embodiment can perform conductance control on minute regions (that is, control of a concentration distribution of impurity diffusion) with high accuracy. In other words, the method of the third embodiment facilitates miniaturization. Therefore, the method of the third embodiment can increase the degree of integration of unit cells. Furthermore, the method of the third embodiment can reduce the occurrence of an interface state, thus reduce on-state resistance, and thus increase a drive current of the transistor.

It should be note that the above-described embodiments are for purpose of facilitating the understanding of the invention and are not intended to limit the scope of the invention. The structural components disclosed in connection with the above-mentioned embodiments are therefore intended to cover all such design changes and equivalences as fall within the technical scope of the invention. Although all the embodiments have been described above giving as an example the semiconductor device in which silicon carbide is used as the material for the semiconductor base 100, other semiconductor materials, such as silicon, silicon germanium, gallium nitride or diamond, may be used as the material for the base. In all the embodiments, silicon carbide of polytype 4H, 6H or 3C or other polytypes is available. Although the third embodiment has been described giving as an example a so-called vertical transistor in which the drain electrode 15 and the source electrode 12 are disposed facing each other with a drain region in between so as to pass a drain current in a vertical direction, a so-called lateral transistor, for example, may be used in which the drain electrode 15 and the source electrode 12 are disposed on the same main surface so as to pass a drain current in a lateral direction. Although the third embodiment has been described giving an instance in which polycrystalline silicon is used as the material for the hetero-semiconductor region 3 or 13, any material may be used provided only that it forms a heterojunction with silicon carbide. Although the first and third embodiments have been described giving an instance in which the silicon carbide base 100 configured of the silicon carbide substrate 1 and the silicon carbide epitaxial layer 2 is of the n type, it goes without saying that the base 100 may be of the p type. Although the first and third embodiments have been described giving an instance in which the single crystal silicon substrate 200 and the hetero-semiconductor region 3 are of the p type, the substrate 200 and the region 3 may be of the n type. Although the third embodiment has been described giving an instance in which n type silicon carbide (SiC) and n type polycrystalline silicon are used for the drain region and the hetero-semiconductor region 3 respectively, a combination of either n type SiC and p type polycrystalline silicon, p type SiC and p type polycrystalline silicon, or p type SiC and n type polycrystalline silicon may be used for the drain region and the hetero-semiconductor region 3.

Although the invention is not limited to the embodiments described above. Modifications and variations of the embodiments described above will occur to those skilled in the art, in light of the teachings. The scope of the invention is defined with reference to the following claims.

## Claims

1. A method of manufacturing a semiconductor device,
the semiconductor device comprising:
a semiconductor base (100) made of a first semiconductor material; and
a hetero-semiconductor region (3) made of a second semiconductor material having a different band gap from the first semiconductor material and forming a heterojunction (300) with the semiconductor base (100),
wherein the formation of the heterojunction (300) is accomplished by bonding together the semiconductor base (100) and a substrate (200) made of the second semiconductor material.

2. A method of manufacturing a semiconductor device,
a semiconductor device comprising:
a semiconductor base (100) made of a first semiconductor material;
a hetero-semiconductor region (3) made of a second semiconductor material having a different band gap from the first semiconductor material and forming a heterojunction (300) with the semiconductor base (100);
a cathode (7) formed in contact with the semiconductor base (100); and
an anode (6) formed in contact with the hetero-semiconductor region (3),
wherein the formation of the heterojunction (300) is accomplished by bonding together the semiconductor base (100) and a substrate (200) made of the second semiconductor material.

3. A method of manufacturing a semiconductor device,
the semiconductor device comprising:
a semiconductor base (100) made of a first semiconductor material;
one or more hetero-semiconductor regions (3) having a different band gap from the first semiconductor material and forming one or more heterojunctions (300) with the semiconductor base (100);
a gate electrode (11) disposed adjacent to the heterojunctions (300) and in contact with the heterojunctions (300) with a gate insulating film (10) in between;
a source electrode (12) formed in contact with the one or more hetero-semiconductor regions (3); and
a drain electrode (15) formed in contact with the semiconductor base (100),
wherein the formation of the heterojunction (300) is accomplished by bonding together the semiconductor base (100) and a substrate (200) made of the second semiconductor material.

4. The method of manufacturing a semiconductor device according to any one of claims 1 to 3, comprising:
implanting hydrogen ions in a predetermined region (202) of the substrate (200);
bonding together the substrate (200) and the semiconductor base (100); and
separating a part of the substrate (200) along a boundary formed by the predetermined region (202) implanted with the hydrogen ions.

5. The method of manufacturing a semiconductor device according to any one of claims 1 to 3, comprising:
implanting hydrogen ions in a predetermined region (202) of the semiconductor base (100);
bonding together the semiconductor base (100) and the substrate (200); and
separating a part of the semiconductor base (100) along a boundary formed by the predetermined region (202) implanted with the hydrogen ions.

6. The method of manufacturing a semiconductor device according to any one of claims 1 to 5, wherein the first semiconductor material is silicon carbide.

7. The method of manufacturing a semiconductor device according to any one of claims 1 to 6, wherein the second semiconductor material is silicon.

## Amended claims

### Amended claims in accordance with Rule 137(2) EPC.

**1.** A method of manufacturing a semiconductor device,
the semiconductor device comprising:
a first semiconductor layer (8) made of a first semiconductor material (400) having a band gap wider than that of silicon; and
a hetero-semiconductor region (3) made of a second semiconductor material having a different band gap from the first semiconductor material and forming a heterojunction (300) with the first semiconductor layer (8), comprising the steps of:
implanting hydrogen ions (201) in a region (202) of a first semiconductor base (400) made of the first semiconductor material;
bonding together the first semiconductor base (400) and a second semiconductor base (200) made of the second semiconductor material; and
separating a part of the first semiconductor base (400) along a boundary formed by the p region (202) implanted with said hydrogen ions (201), thereby using the first semiconductor base (400) bonded with the second semiconductor base (200) as the first semiconductor layer.

**2.** A method of manufacturing a semiconductor device according to claim 1,
wherein the semiconductor devices further comprises:
a cathode (7) formed in contact with the semiconductor base (100); and
an anode (6) formed in contact with the hetero-semiconductor region (3).

**3.** The method of manufacturing a semiconductor device according to any one of claims 1 to 2, wherein the first semiconductor material (400) is silicon carbide.

**4.** The method of manufacturing a semiconductor device according to any one of claims 1 to 3, wherein the second semiconductor material (200) is silicon.
